Europäisches Patentamt

(19) European Patent Office

Office européen des brevets

(11) Publication number: **0 053 912**
A1

## (12) EUROPEAN PATENT APPLICATION

(21) Application number: **81305696.7**

(22) Date of filing: **03.12.81**

(51) Int. Cl.³: **H 01 L 21/316**
//H01L39/22

(30) Priority: **10.12.80 US 214929**

(43) Date of publication of application:
**16.06.82 Bulletin 82/24**

(84) Designated Contracting States:
**DE FR GB IT**

(71) Applicant: **International Business Machines Corporation**

**Armonk, N.Y. 10504(US)**

(72) Inventor: **Cuomo, Jerome John**
**P.O. Box 353**
**Lincolndale New York 10598(US)**

(72) Inventor: **Harper, James McKell Edwin**
**507 Elizabeth Road**
**Yorktown Heights New York 10598(US)**

(74) Representative: **Richards, John Peter**
**IBM UNITED KINGDOM PATENT OPERATIONS Hursley Park**
**Winchester Hants, SO21 2JN(GB)**

(54) **Process for oxidising a metal sample.**

(57) A surface reaction process for controlled oxide growth is disclosed using a directed, low energy ion beam for oxide formation. In particular Ni-oxide-Ni and Cr-oxide-Ni tunnelling junctions are fabricated using broad directed beams of oxygen ions with energies ranging from 30 to 180 eV and a background pressure of 0.3 mTorr or less. Junction resistance decreases with increasing ion energy, and oxidation time dependence shows a characteristic saturation, both consistent with a process of simultaneous oxidation and sputter etching.

- 1 -

## PROCESS FOR OXIDISING A METAL SAMPLE

The present invention relates a process for oxidising the surface of a metal sample.

Recent demands in the applications of metal-oxide-metal devices (MOM's) require very small areas and thin structures. In room temperature applications, MOM's have been employed as infrared detectors and mixers up to the near infrared. In cryogenic applications, MOM's are being used as Josephson junction switches in computer circuits and as detectors and mixers in the submillimeter range. These devices require a uniform oxide thickness in the range 5 - 25 Å, which is difficult to achieve reproducibly using thermal or plasma oxidation.

An r.f. oxidation process developed by J. H. Greiner is described in United States Patent No. 3,849,276. The Greiner process combines simultaneous oxidation with sputter etching in an r.f. plasma to produce a steady-state oxide thickness. In the r.f. oxidation process disclosed by Greiner, oxygen ions strike the metal with a broad range of energies since the ions are extracted from a plasma. Ions with kinetic energy less than the sputter threshold energy oxidize the metal, while ions with higher kinetic energy sputter etch the metal and oxide. If the initial oxidation rate is higher than the sputtering rate, a certain oxide thickness will be established after a characteristic time, determined by the rate of decrease in the oxidation rate with oxide thickness, and by the sputtering rate. Continuation of the process for a time, which is longer than needed for having oxidation rate and sputtering rate equal, will assure a pinhole free oxide with a reproducible final thickness.

Several known drawbacks limit the usefulness of the r.f. oxidation technique. (1) Processing parameters are interdependent. Changing the pressure, for example, changes both the ion acceleration voltage and current density. (2) Energetic electron bombardment heats up the sample and hastens oxidation. (3) The plasma is at an elevated potential relative to the chamber walls, resulting in a constant sputtering of the walls. (4) Sputtered atoms scatter from the gas back onto the sample, contaminating the oxide. At a pressure of 10 mTorr, typically used in r.f. oxidation, the mean free path for backsputtered neutrals is only a few mm, and it has been found, for example, that the current density of superconducting tunnel junctions is greatly affected by the presence of backsputtered material.

Broad beam multiaperture ion sources, known in the art as "Kaufman sources", are widely used for etching applications, and energetic ion beams have been used to carry out reactive processes in a variety of configurations, such as disclosed by J. A. Taylor, G. M. Lancaster, A. Ignatiev, and J. W. Rabalais in the Journal of Chem. Physics, Vol. 68, No. 4, page 1776 (1978). Recently, A. W. Kleinsasser and R. A. Buhrman, in the 9th International Conference on Electron and Ion Beam Science and Technology, St. Louis, Mo. (1980), reported the fabrication of Josephson junctions by ion beam oxidation of Nb, using an $Ar/O_2$ ion beam with an energy of 600 eV. In this latter work, however, oxidation occurred rapidly and was not the result of combined oxide growth and sputter etching.

According to the present invention there is provided a process for oxidising the surface of a metal sample, comprising placing the sample into a vacuum chamber containing an ion source having a plasma discharge chamber, forming an ion plasma within the plasma discharge chamber, the ion plasma being fed with oxygen to form a solid oxide when reacted with the surface of the sample, and the gas pressure in the vacuum chamber being less than 0.3 millitorr, extracting ions from the ion plasma to form a broad ion beam directed at the sample, and adjusting the energy of the beam within the range 30 - 180 eV to provide a desired equilibrium thickness of oxide by simultaneous etching and oxide formation.

Metal-oxide-metal junctions made by the technique according to the present invention show a junction resistance which decreases with increasing ion energy, and oxidation time dependence shows a characteristic saturation, both consistent with a process of simultaneous oxidation and sputter etching, as in the conventional r.f. oxidation process. In contrast with r.f. oxidized junctions, however, ion beam oxidized junctions contain less contamination by backsputtering due to the low pressure in the vacuum chamber which is required to ensure integrity of the directed beam between the ion source and the sample, and the quantitative nature of ion beam techniques allows greater control over the growth process, in particular by permitting substantially independent control of the ion beam current density and the ion beam energy.

Further advantages of the ion beam technique are that the sample is isolated from the ion generation plasma, and the vacuum chamber walls are not subjected to energetic ion bombardment, since the beam is directed. Furthermore, the ions have a narrow energy spread (10-20 eV), enabling easier analysis.

In the accompanying figures:

FIG. 1 is a schematic diagram of an ion beam oxidation system for carrying out a process according to the present invention;

FIG. 2 shows a cross-sectional portion of a metal-oxide-metal junction formed on a substrate by an ion beam oxidation process of the present invention;

- 4 -

FIG. 3 is a perspective view of the junction of Figure 2;

FIG. 4 is a graph of the current-voltage characteristics of nickel-oxide-nickel junctions fabricated by an ion beam oxidation process of the present invention;

FIG. 5 is a graph showing the dependence of junction resistance on oxygen ion beam energy; and

FIG. 6 is a graph showing the relationship between junction resistance and ion beam oxidation time.

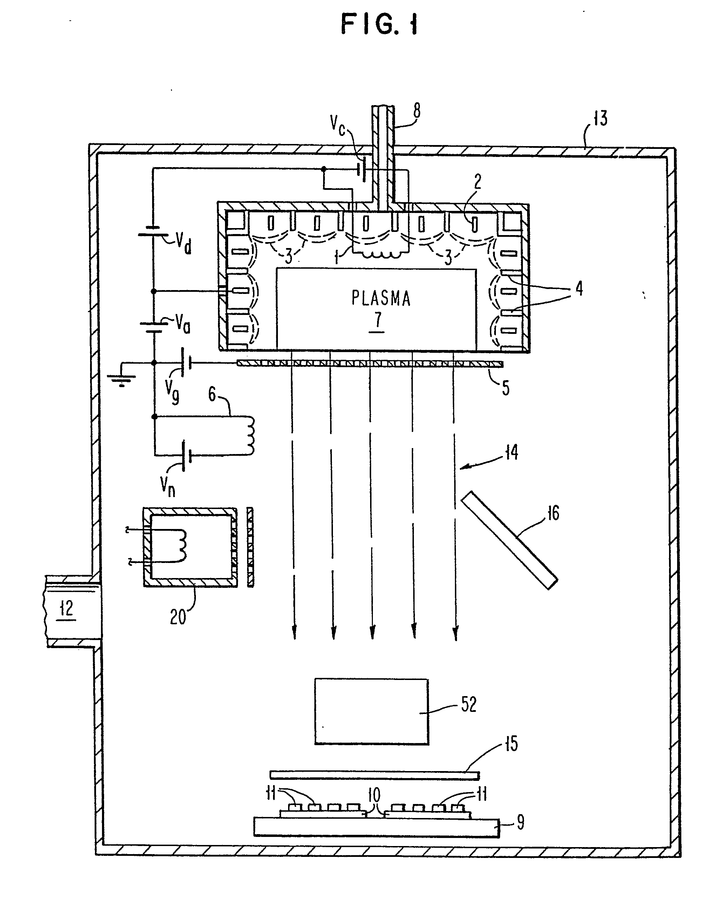

FIG. 1 is a schematic diagram of an ion beam oxidation system for performing a process in accordance with the present invention. Generally, the system includes a single grid ion source for sputter cleaning and oxidation, a dual grid ion source 20 for overcoating of junctions, a movable ion energy analyzer 52, and a sample 10 on a water cooled holder 9 for maintaining the sample at or near room temperature. The single grid ion source together with wafers 10 and holder 9 are contained within a vacuum chamber 13. The ion source includes a plasma chamber containing a thermionic cathode 1 and a plurality of anodes 2 disposed around the cathode adjacent the walls of the plasma chamber and made of non-magnetic material such as stainless steel. The anodes 2 are located between pole pieces 4 on both sides of the anodes 2. The pole pieces 4 are made of a magnetically permeable material such as soft iron. A magnetic field is indicated by broken lines 3. Oxygen gas is introduced into the plasma chamber through a gas inlet 8. The gas is ionized by electrons from the cathode 1 which are accelerated to the anodes 2. Magnetic field lines 3 produced between the pole pieces 4 enhance the ionization efficiency. A multi-aperture accelerator grid 5 is shown at the lower end of the plasma chamber. A plasma 7 is formed by the ions and electrons in the plasma chamber and provides a source of ions for the ion beam. These ions are extracted from the plasma 7 to the apertures in the accelerator grid 5 and form a broad
directed beam of low energy and high current density as shown by
the ion trajectory lines 14 in FIG. 1. A movable shutter 15 can
be used to protect the sample 10 while a retarding grid energy
analyzer 52 is moved into the beam path to measure the ion beam
energy distribution and current density. In general we have
found that the energy of the beam should be from 30 to 180 eV
for oxidation by the present invention, although it is to be
understood that the values at the extremes of this range may not
be suitable for all sample materials. The ion beam current
density can be up to several $mA/cm^2$ at this low energy, and is
controllable independently of the ion beam energy.

Electrons are added to the beam 14 from a neutralizer 6 to
prevent charging up of the insulating wafers 10. The wafers 10
to be oxidized are bombarded with the low energy ion beam 14,
the wafers 10 having masking material 11 selectively thereon for
delineating the desired oxide patterns. Reactive species in the
beam 14 combine with atoms in the wafer 10 to form a solid oxide
compound with the sample material. Excess gas is removed by a
pumping port 12 from the vacuum chamber 13. The pressure in the
vacuum chamber 13 is 0.3 millitorr or less during actual oxidation.

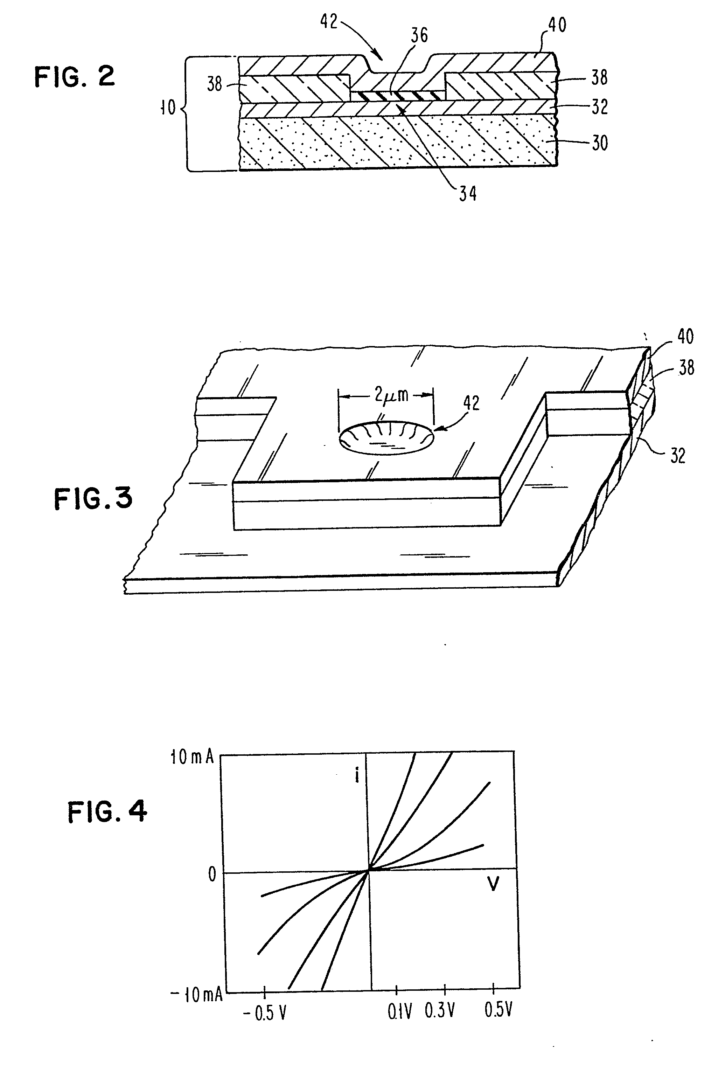

Various samples 10 to be oxidized were mounted with gallium
backing on the water cooled copper block or wafer holder 9,
having been previously prepared by sputter coating Si wafers 30
(Fig. 2) with 1000 Å of either Ni or Cr 32 followed by a layer
of 1000 Å of $SiO_2$ 38 as masking material. The $SiO_2$ had been
chemically etched to define junction areas 34 of from 5 $\mu m^2$ to
40 $\mu m^2$, in which the oxide was grown. A 7 cm diameter ion
source equipped with a Ni mesh single grid 5 of 100 lines/inch
faced the samples 10 at a distance of 15 cm and performed both
precleaning and oxidation of the samples 10. After oxidation,
the separate ion source 20 directed a 2.0 cm diameter beam at a movable Ni target 16 to overcoat the oxidized samples with a Ni counterelectrode 40. A close-up view of a metal-oxide-metal junction formed by the above system is provided in FIGS. 2 and 3, and will be described below.

Typical parameters of the single grid ion source are as follows: $V_c$ for heating the cathode 1 typically supplies 13 amps; $V_d$ (discharge voltage) needed to sustain the plasma is 40 volts for Ar and 70 volts for $O_2$; $V_a$ (anode voltage) is approximately equal to the desired ion energy (30 - 180 eV); $V_g$ or grid voltage is equal to minus 10 V; $V_n$ (neutralizer heater) typically supplies 6.5 amps. The gas pressure in the vacuum chamber is no greater than 0.3 mTorr to maintain the integrity of the directed beam and minimise backsputtering.

The dual grid ion source 20 is operated to produce an 800 eV, 12 mA $Ar^+$ ion beam for a deposition rate of nickel of about 2 $\overset{o}{A}$/sec.

After initially pumping the vacuum chamber to about $5 \times 10^{-7}$ Torr, Ar gas was introduced to a pressure of 0.3 mTorr. The samples were then sputter etched (pre-cleaned) using the single grid ion source for 5 minutes using $Ar^+$ ions at 150 eV and 0.72 mA/cm$^2$, to remove several hundred $\overset{o}{A}$ of Ni in the junction areas. Argon was next replaced with oxygen and the beam adjusted to desired conditions as to ion beam density and energy (30-180 eV) using the analyzer 52. The samples were then oxidized with the low energy oxygen ion beam of 30 eV to 180 eV with the vacuum chamber pressure maintained at 0.3 mTorr. The Ni target was next resputtered with $Ar^+$ for 5 minutes, with the sample protected, to remove any oxide formed on the target during oxidation, followed by overcoating of the sample with 500 - 1000 $\overset{o}{A}$ of Ni 40 using the dual grid ion source 20. Multiple samples could be oxidized and overcoated independently in one pumping cycle of the system. Alternate thin film deposition source means, such as an evaporation source, may be provided in place of ion source 20, for depositing additional thin film layers for electrical devices. The samples were then removed from the vacuum system. FIGS. 2 and 3 show cross-section and perspective views respectively of a portion of a metal-oxide-metal junction consisting of a silicon substrate 30, a nickel bottom electrode 32 and junction regions 34 delineated by $SiO_2$ masking layer 38. Ion beam oxidation was used to grow the thin oxide layer 36 in the junction region 34. The nickel top electrode 40 was deposited on the oxide layer 36 to complete the metal-oxide-metal junction. The junction area is located in the recess 42.

Various nickel and chromium metal films were processed as above by oxygen ion beams with an energy ranging from 30 eV to 180 eV and a current density of 0.72 $mA/cm^2$ for times ranging from 10 sec to 30 min, the pressure being 0.3 mTorr. For each oxide junction, the dynamic resistance was measured at zero bias as an indicator of oxide thickness. To indicate the range of values obtainable, current-voltage curves are shown in FIG. 4 for nickel-oxide-nickel junctions fabricated by ion beam oxidation. For low oxygen ion energy (30 - 40 eV), junction resistances of 10 k$\Omega$ or higher are obtained after several minutes oxidation (the curve of lowest slope in FIG. 4). By increasing the oxygen ion energy, the junction resistance decreases to as low as 25 $\Omega$ for energies above 100 eV, the curve of the highest slope in FIG. 4. Junctions are stable under biasing, with breakdown voltages of 1.5-2.5V at room temperature. Here the wire resistance is 20 ohms.

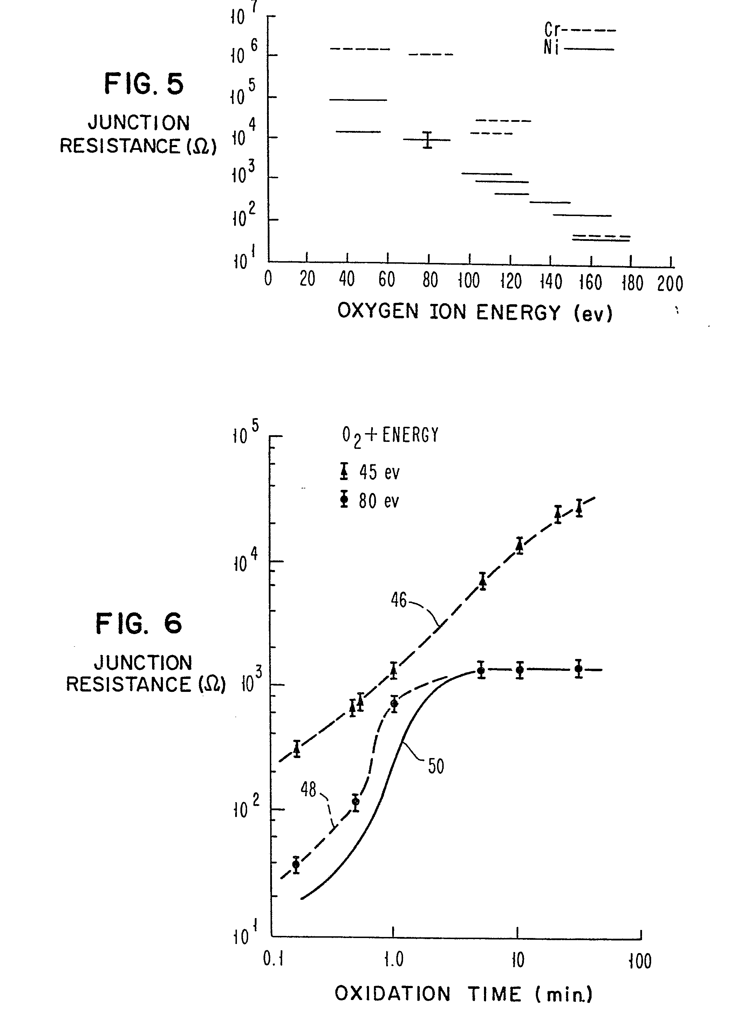

The dependence of junction resistance (10 $\mu m^2$ area) on oxygen ion beam energy is shown in FIG. 5 for both nickel and chromium junctions oxidized for 10 minutes at an oxygen ion current density of 0.72 mA/cm$^2$. The junction resistance is a measure of oxide thickness. The spread of ion energy in the beam, typically 20 eV, is indicated by the width of each line shown for each resistance value. As indicated in FIG. 4, junction resistance of nickel and chromium MOM's decreases with increasing oxygen ion beam energy, due to increased sputter etching resulting in a thinner oxide layer. Chromium MOM's have somewhat higher resistances due to the greater reactivity of chromium.

Time dependence of junction resistance was also examined for ion beam oxidized Ni junctions as shown in FIG. 6. At an oxygen ion energy of 45 eV, the nickel junction resistance indicated by curve 46 increases monotonically with oxidation time, indicating an oxide growth component with negligible sputter etching. For an oxygen ion energy of 80 eV, however, the junction resistance indicated by curve 48 attains a maximum after several minutes, indicating the formation of a steady state oxide thickness.

Some parameters governing the oxide growth can be deduced from FIG. 6. It is assumed that the junction tunnelling resistance at low bias voltage is given by $R(x) = (A/x)\exp(B\phi^{1/2}x)$, where R is the dynamic resistance at zero bias, x is thickness, $\phi$ is the barrier height, and A and B are constants. For a barrier height of 1 eV, an oxide thickness of 10 Å leads to a resistance of 1.5 k$\Omega$. We now assume that the oxide growth rate is given by an exponentially decreasing function of thickness in combination with a constant sputter etching rate $dx/dt = K \exp(-x/X_o) - E$ where K is the initial oxidation rate in the absence of sputtering, $X_o$ is a constant determined by the rate of oxygen diffusion through the oxide, and E is the sputter etching rate. This analysis is described by Greiner in the aforementioned U.S. Patent 3,849,276. In the presence of sputtering, the final oxide

thickness is $X_o \ln(K/E)$, which is approached with a time constant $X_o/E$. From the data for an ion energy of 80 eV, shown in FIG. 6, we estimate a time constant of about 1 min. Assuming a sputtering rate of about 2 $\overset{o}{A}$/min for nickel oxide under 80 eV $O_2^+$ bombardment at 0.72 mA/cm$^2$, we get $X_o = 2$ $\overset{o}{A}$. We now express the junction resistance as a function of time: $\ln R = C + B\phi^{1/2} X_o \ln t$ where $C = \ln A - \ln x + B\phi^{1/2} X_o \ln(K/X_o)$. C can be regarded as a constant due to the weak dependence of $\ln x$ on t. The linear dependence of $\ln R$ on $\ln t$ is qualitatively seen in the 45 eV curve of FIG. 6.

From the final resistance of 1.5k$\Omega$, one gets $K \underset{\sim}{\sim} 5$ $\overset{o}{A}$/sec. This value of initial oxidation rate is reasonable since the arrival rate of oxygen ions at 0.72 mA/cm$^2$ corresponds to approximately one monolayer of oxygen per second. If each ion were incorporated in the oxide, the growth rate would be several $\overset{o}{A}$/sec. Substituting $X_o$, E, and K in x(t) for the general case of sputter-oxidation leads to $x(t) \underset{\sim}{\sim} 2 \ln 150 [1 - \exp(-t)]$. Using the equation for R(x), the resistance is plotted as a solid curve 50 in FIG. 6 with a fairly good agreement with the measured resistances. The results indicate that a combined oxidation and sputtering process is responsible for the junction resistances.

To further characterize the oxidation processes, Auger surface analysis spectroscopy was performed on ion beam oxidized Ni and Cr samples after air transfer. In all samples, 40-60% carbon contamination was detected, probably due to the air transfer and the exposure to diffusion pump vapour. It is known that in r.f. oxidized samples, large amounts of contaminant material, such as molybdenum, back-sputtered from the sample holder, are observed in addition to the metal and oxygen in the oxide. By contrast, backsputtered material such as Mo was not detected in significant quantities in ion beam oxidized films, indicating the advantage of operating at low pressure where the mean free path of ions and sputtered atoms is of the same order or greater than the linear dimensions of the vacuum chamber.

- 10 -

Thus, there has been demonstrated a new process of metal oxidation which incorporates the advantages of low energy ion beams. The process is easily controlled and reproducible, and the resulting oxide junctions are of high quality and free of the contaminants usually found in the r.f. oxidation process.

CLAIMS

1.   A process for oxidising the surface of a metal sample, comprising placing the sample into a vacuum chamber containing an ion source having a plasma discharge chamber, forming an ion plasma within the plasma discharge chamber, the ion plasma being fed with oxygen to form a solid oxide when reacted with the surface of the sample, and the gas pressure in the vacuum chamber being less than 0.3 millitorr, extracting ions from the ion plasma to form a broad ion beam directed at the sample, and adjusting the energy of the beam within the range 30 - 180 eV to provide a desired equilibrium thickness of oxide by simultaneous etching and oxide formation.

2.   A process as claimed in Claim 1, wherein the ion source is an electron bombardment ion source having an anode and a cathode, and the adjustment of the beam energy is achieved by adjusting the voltage potential applied to the ion source at the anode.

3.   A process as claimed in Claim 2, wherein the step of extracting the ions from the ion plasma to form a broad ion beam is carried out by a single extraction grid having multiple apertures.

4.   A process as claimed in Claim 1, 2 or 3, wherein the sample is maintained at or near room temperature.

# FIG. 1

FIG. 2

FIG.3

FIG. 4

FIG. 5

JUNCTION
RESISTANCE (Ω)

Cr ------
Ni ——

OXYGEN ION ENERGY (ev)

FIG. 6

JUNCTION
RESISTANCE (Ω)

$O_2$ + ENERGY

45 ev
80 ev

46

48

50

OXIDATION TIME (min.)

0053912

European Patent
Office

**EUROPEAN SEARCH REPORT**

Application number

EP 81 30 5696

| Category | Citation of document with indication, where appropriate, of relevant passages | Relevant to claim |
|---|---|---|
| X,Y | ELECTRONICS LETTERS, vol. 16, no. 22, October 1980 LONDON (GB) R. HERWIG: "Ion beam oxidation of Nb-based Josephson junctions" pages 850-851 <br><br> * entire document * | 1-4 |
| Y | THIN SOLID FILMS, vol. 45, 1977 LAUSANNE (CH) J.R. SITES: "Semiconductor applications of thin films deposited by neutralised ion beam sputtering" pages 47-53 <br><br> * page 49, figure 1 * | 3 |
| A | APPLIED PHYSICS LETTERS, vol. 37, no. 9, November 1, 1980 NEW YORK (US) A.W. KLEINSASSER et al.: "High-quality submicron niobium tunnel junctions with reactive-ion-beam oxidation" pages 841-843 | |

## DOCUMENTS CONSIDERED TO BE RELEVANT

**CLASSIFICATION OF THE APPLICATION (Int. Cl. 3)**

H 01 L 21/316
//H 01 L 39/22

**TECHNICAL FIELDS SEARCHED (Int.Cl. 3)**

H 01 L 21
H 01 L 39

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

The present search report has been drawn up for all claims

| Place of search | Date of completion of the search | Examiner |
|---|---|---|
| The Hague | 1982 | PELSERS |

EPO Form 1503.1 06.78